# DEMANDE DE BREVET EUROPEEN

(11) **EP 4 017 235 A1**
(43) Date de publication de la demande: **22.06.2022**
(21) Numéro de dépôt: 21214926.4
(22) Date de dépôt: 15.12.2021
(51) Int. Cl.: H05K 7/20

(54) **MODULE DE REFROIDISSEMENT POUR UN ENSEMBLE ÉLECTRIQUE**

(30) Priorité: 18.12.2020 FR 2013705
(71) Demandeur: Valeo Siemens eAutomotive France SAS, 95800 Cergy (FR)
(72) Inventeur: LEGENDRE, Alexandre, 95800 Cergy (FR); POUILLY, Aurelien, 95800 Cergy (FR)
(74) Mandataire: Novembre, Christophe Adelphe

(57) **Abrégé**

L'invention concerne une unité de refroidissement (101a, 101b) pour dissiper la chaleur générée par des composants électroniques (40) d'un ensemble électrique (1), l'unité de refroidissement (101a, 101b) comprenant une première portion (20) et une deuxième portion (30), formant chacune une partie creuse, de forme sensiblement parallélépipédique. Les première et deuxième portions (20, 30) se rejoignent en une zone de jonction (51) de l'unité de refroidissement (101a, 101b), les première et deuxième portions (20, 30) comprenant chacune une première surface externe (22, 32) tournée vers l'autre portion (32, 22), et lesdites premières surfaces externes (22, 32) comprenant chacune une zone de réception destinée à recevoir un ou plusieurs desdits composants électroniques (40). Au moins une desdites portions (20, 30) comprend une ouverture de connexion (25 ou 35) configurée pour être connectée, à une autre partie dudit module de refroidissement (10) qui est distincte de ladite unité de refroidissement. L'unité refroidissement (101a, 101b) comprend en outre au moins un orifice (55) formé dans l'une des portions (20,30).

## Description

### DOMAINE TECHNIQUE ET OBJET DE L'INVENTION

La présente invention se rapporte au domaine des équipements électriques, notamment pour véhicule, en particulier pour véhicules électriques (« EV », abréviation anglaise) ou hybrides (« HEV », abréviation anglaise).

L'invention porte plus particulièrement sur un ensemble électrique comprenant un module de refroidissement utilisé pour dissiper la chaleur générée par des composants électroniques dudit ensemble électrique.

### ETAT DE LA TECHNIQUE

Une unité électronique de puissance pour un véhicule électrique ou hybride, tel qu'un onduleur, comprend des composants électroniques qui génèrent beaucoup de chaleur, tels que des composants électroniques de puissance et des composants capacitifs. Le nombre de composants électroniques de puissance peut correspondre avec le nombre de phases d'un moteur commandé par l'onduleur (qui est égal par exemple à trois).

Lors du fonctionnement d'une unité électronique de puissance, les composants électroniques chauffent et doivent donc être refroidis pour être opérationnels à leur rendement optimal. Un refroidissement efficace des composants électroniques permet d'augmenter la durée de vie des composants électroniques. L'unité électronique de puissance comprend ainsi un module de refroidissement pour dissiper la chaleur générée par ces composants électroniques.

En fonction des formes et des emplacements de ces composants électroniques, la forme et la structure du module de refroidissement peut être compliquée et difficile à fabriquer. Ainsi, il existe des modules de refroidissement composés de plusieurs pièces de refroidissement de formes et de structures différentes pour s'adapter aux composants électroniques.

Il existe néanmoins des problèmes concernant l'assemblage et l'interconnexion des composants électroniques et des pièces de refroidissement. L'assemblage peut être très compliqué à réaliser.

Il existe donc un besoin pour un module de refroidissement qui est facile à assembler, moins volumineux et moins coûteux, plus léger et robuste que les systèmes de refroidissement conventionnels.

### PRESENTATION GENERALE DE L'INVENTION

Pour parvenir à ce résultat, la présente invention concerne une unité de refroidissement pour former un module de refroidissement configuré pour dissiper la chaleur générée par des composants électroniques d'un ensemble électrique, l'unité de refroidissement comprenant une première portion et une deuxième portion, chacune étant de forme sensiblement parallélépipédique et formant une partie creuse respective. L'unité de refroidissement selon l'invention est remarquable en ce que :
les première et deuxième portions se rejoignent en une zone de jonction de l'unité de refroidissement, les première et deuxième portions comprenant chacune une première surface externe tournée vers l'autre portion, et lesdites premières surfaces externes comprenant chacune une zone de réception destinée à recevoir un ou plusieurs desdits composants électroniques ;
au moins une desdites portions comprend une ouverture de connexion configurée pour être connectée, à une autre partie dudit module de refroidissement qui est distincte de ladite unité de refroidissement;
l'unité refroidissement comprend en outre au moins un orifice formé dans l'une des portions, dite portion d'entrée/sortie, l'orifice débouchant dans la partie creuse de ladite portion, l'orifice étant utilisé comme une entrée de fluide ou une sortie de fluide du module de refroidissement.

Les unités de refroidissement selon l'invention présentent une structure simple et robuste. Elles sont faciles à fabriquer (e.g. à mouler) et à assembler pour former un circuit de refroidissement.

En particulier, lesdites premières surfaces externes forment un angle entre elles.

Notamment, l'au moins une ouverture de connexion est configurée pour être connectée à une autre partie dudit module de refroidissement de manière étanche.

Avantageusement, la première portion comprend une ouverture de connexion située à une extrémité de la première portion qui est distale de la zone de jonction de l'unité de refroidissement.

De façon avantageuse, la deuxième portion comprend une ouverture de connexion formée à sa première surface externe, et qui se situe dans une zone différente de la zone de réception de ladite première surface externe de la deuxième portion.

Avantageusement, les parties creuses sont configurées pour permettre la circulation d'un fluide de refroidissement.

Selon un mode de réalisation, un angle intérieur entre les première et deuxième portions de l'unité de refroidissement est égal à 90 degrés.

De façon avantageuse, l'orifice est formé sur une deuxième surface externe de la portion d'entrée/sortie, ladite deuxième surface externe étant opposée à ladite première surface externe de la portion d'entrée/sortie.

L'invention concerne également un module de refroidissement.

Le module de refroidissement est composé d'unités de refroidissement identiques, ce qui permet, d'une part, de simplifier la fabrication du module de refroidissement et de l'ensemble électrique et, d'autre part, de l'adapter à divers composants électroniques. Il n'est plus besoin de fabriquer des pièces de refroidissement de divers formes et structures.

Le module de refroidissement est destiné à être intégré dans un ensemble électrique d'un véhicule automobile électrique ou hybride pour dissiper la chaleur générée par des composants électroniques de l'ensemble électrique, et comprend des unités de refroidissement respectivement telles que brièvement décrites ci-dessus.

Selon un mode de réalisation, les unités de refroidissement sont assemblées de sorte à former un circuit de refroidissement à fluide configuré pour acheminer un fluide de refroidissement.

De façon avantageuse :
un nombre d'unités de refroidissement est égal à deux ;
pour chacune des unités de refroidissement, la première portion comprend une première ouverture de connexion, et la deuxième portion comprend une deuxième ouverture de connexion ;
les première et deuxième ouvertures de connexion de l'une des unités de refroidissement sont respectivement connectées, de manière étanche, à la deuxième ouverture de connexion et à la première ouverture de connexion de l'autre des unités de refroidissement.

Selon un mode de réalisation, l'orifice de l'une des unités de refroidissement, et celui de l'autre des unités de refroidissement, sont respectivement utilisés comme une entrée de fluide et comme une sortie de fluide du module de refroidissement.

Avantageusement, le module de refroidissement comprend le fluide de refroidissement utilisé pour dissiper la chaleur générée par les composants électroniques.

L'invention vise également un ensemble électrique pour un véhicule automobile électrique ou hybride, comprenant des composants électroniques et un module de refroidissement tel que brièvement décrit ci-dessus.

Avantageusement, les composants électroniques comprennent un ou plusieurs composants électroniques de puissance, et/ou un ou plusieurs composants capacitifs.

Selon un mode de réalisation, ledit ensemble électrique forme un onduleur ou un convertisseur de tension continu-continu.

### PRESENTATION DES FIGURES

L'invention sera mieux comprise à la lecture de la description qui va suivre, donnée à titre d'exemple, et se référant aux figures suivantes, données à titre d'exemples non limitatifs, dans lesquelles des références identiques sont données à des objets semblables.
La figure 1 illustre, selon un mode de réalisation de l'invention, une vue d'un module de refroidissement avant l'assemblage, le module de refroidissement étant destiné à être intégré dans un ensemble électrique ;
La figure 2 illustre une vue de l'ensemble électrique avec le module de refroidissement intégré après l'assemblage, selon un mode de réalisation de l'invention ; et
La figure 3 illustre une vue de l'ensemble électrique les unités de refroidissement du module de refroidissement selon un mode de réalisation de l'invention étant transparents pour montrer la circulation d'un fluide de refroidissement.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE DE L'INVENTION

L'invention concerne un module de refroidissement 10, destiné à être intégré dans un ensemble électrique 1 configuré pour être embarqué dans un véhicule automobile électrique ou hybride. L'ensemble électrique 1 est, par exemple, une unité d'électronique de puissance, notamment un onduleur ou un convertisseur de tension continu-continu.

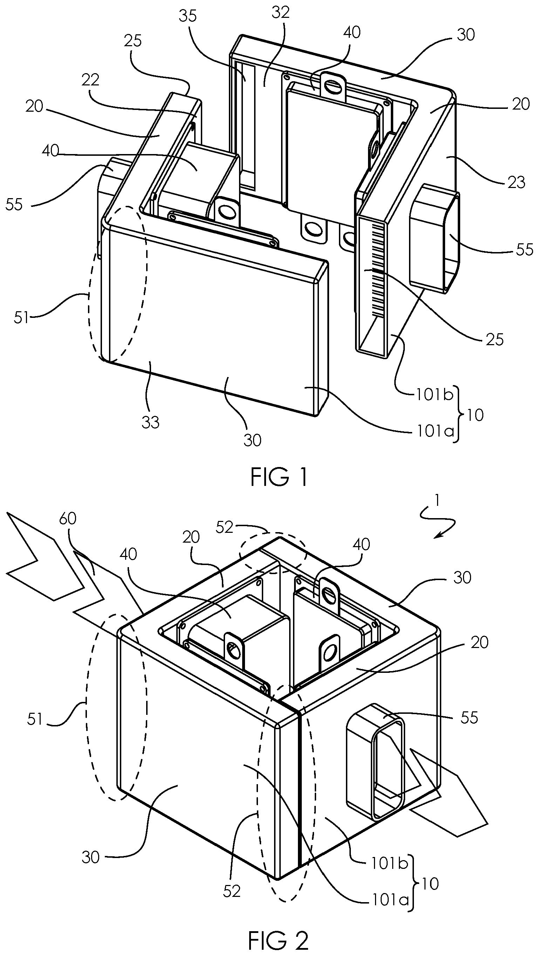

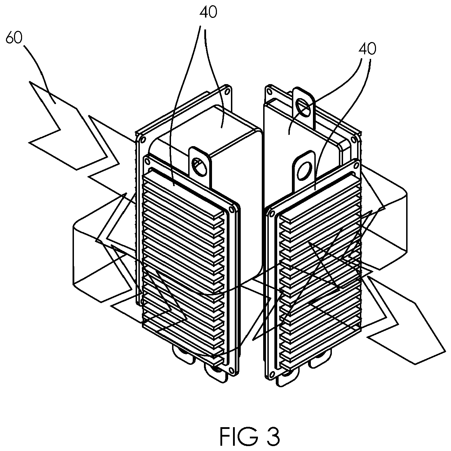

La figure 1 et la figure 2 illustrent une vue du module de refroidissement 10 avant et après l'assemblage, selon un mode de réalisation de l'invention. La figure 3 illustre une vue de l'ensemble électrique 1, les unités de refroidissement du module de refroidissement 10 étant en transparence pour montrer une circulation d'un fluide de refroidissement 60. Le fluide de refroidissement 60 est par exemple de l'eau ou du glycol liquide.

L'ensemble électrique 1 comprend des composants électroniques 40 qui génèrent la chaleur lors de leurs fonctionnements. Les composants électroniques 40 comprennent un ou plusieurs composants électroniques de puissance, et/ou un ou plusieurs composants capacitifs. Par exemple, l'ensemble électrique 1 comprend quatre composants électroniques 40 dont un est un composant capacitif alors que les trois autres sont des composants électroniques de puissance correspondant respectivement à une des trois phases d'un moteur commandé par l'onduleur 1. L'invention n'est néanmoins ni limitée au nombre de composants électroniques 40 ni aux types de composants électroniques 40.

Le module de refroidissement 10 comprend des unités de refroidissement. L'assemblage des unités de refroidissement permet de former un circuit de refroidissement à fluide configuré pour acheminer le fluide de refroidissement 60. Dans l'exemple illustré en figures 1 à 3, le module de refroidissement 10 comprend deux unités de refroidissement 101a et 101b. L'invention peut comprendre davantage d'unités de refroidissement, en fonction de la forme et de la structure du module de refroidissement 10 souhaité. Dans un autre mode de réalisation où le module de refroidissement 10 est en forme d'hexagone, le module de refroidissement 10 est composé de trois unités de refroidissement.

Notamment, les unités de refroidissements 101a, 101b du module de refroidissement 10 sont identiques en termes de structure, de fonctionnement et, de préférence, de matériau. L'unité de refroidissement (101a ou 101b) est préférentiellement constituée d'un matériau tel que de l'aluminium de type AlSi12(Fe). Alternativement, l'unité de refroidissement (101a ou 101b) peut être constitué de plastique chargé de type PA66 GF30 ou de tout autre matériau présentant des capacités de moulabilité et de tenue mécanique adaptées à une utilisation dans une unité électronique de puissance telle qu'un onduleur. L'unité de refroidissement présente une structure creuse qui permet la circulation du fluide de refroidissement 60.

Les unités de refroidissement comprennent chacune une première portion 20 et une deuxième portion 30. Les premières et deuxièmes portions 20, 30 forment chacune une partie creuse de forme sensiblement parallélépipédique. Lesdites première et deuxième portions 20, 30 présentent chacune une première surface externe 22, 32, respectivement tournée vers la surface externe de l'autre portion. Lesdites premières surfaces externes 22, 32 respectives comprennent chacune une zone de réception destinée à recevoir un ou plusieurs des composants électroniques 40. Les unités de refroidissement sont également utilisées comme des supports de maintien pour fixer et maintenir les composants électroniques 40 en position.

Au moins une des première et deuxième portions 20, 30 de l'unité de refroidissement (101a ou 101b) comprend une ouverture de connexion configurée pour être connectée, de manière étanche, à une autre partie du même module de refroidissement 10 qui est distincte de ladite unité de refroidissement. Ladite autre partie du module de refroidissement 10 peut être une autre unité de refroidissement dudit module de refroidissement 10.

Les première et deuxième portions 20 et 30 de l'unité de refroidissement (101a ou 101b) se rejoignent en une zone de jonction 51 du module de refroidissement 10. De manière préférentielle, les deux portions 20, 30 et la zone de jonction 51 de l'unité de refroidissement sont formées d'un seul tenant. Notamment, un angle intérieur est formé entre les deux portions 20 et 30 de l'unité de refroidissement. Dans un mode de réalisation, l'angle intérieur de l'unité de refroidissement est égal à 90 degrés. Dans ce cas, l'unité de refroidissement est en forme de L. Il est à noter que l'angle intérieur peut être supérieur ou inférieur à 90 degrés. Par exemple, dans un autre mode de réalisation où le module de refroidissement 10 est en forme d'hexagone, l'angle intérieur de chaque unité de refroidissement est de 120 degrés.

Dans un mode de réalisation, la première portion 20 du module de refroidissement 10 comprend une première surface externe 22, une deuxième surface externe 23 qui est opposée, et notamment parallèle, à la première surface externe 22, une (première) ouverture de connexion 25 et une partie creuse. De manière similaire, la deuxième portion 30 comprend une première surface externe 32, une deuxième surface externe 33 qui est opposée, et notamment parallèle, à la première surface externe 32, une (deuxième) ouverture de connexion 35 et une partie creuse. L'angle intérieur entre les deux portions 20 et 30 est alors défini par les premières surfaces externes 22 et 32.

L'unité de refroidissement comprend en outre un orifice 55 formé soit dans la première portion 20 (comme décrit dans l'exemple de figures 1 à 3) soit dans la deuxième portion 30 (non décrit par les figures). L'orifice 55 est utilisé comme une entrée de fluide ou une sortie de fluide du module de refroidissement 10. L'orifice 55, débouchant dans la partie creuse de la première portion 20 ou celle de la deuxième portion 30, est formé à la deuxième surface externe 23 de la première portion 20, ou à la deuxième surface externe 33 de la deuxième portion 30. De manière préférentielle, l'unité de refroidissement et son orifice 55 sont formées d'un seul tenant.

Comme décrit précédemment, les premières surfaces externes 22, 32 comprennent chacune une zone de réception destinée à recevoir un ou plusieurs desdits composants électroniques 40. Plus précisément, l'un ou les composants électroniques 40 comprennent respectivement une surface qui est en contact avec la zone de réception de la première surface externe 22 de la première portion ou avec celle de la première surface externe 32 de la deuxième portion. Ainsi, la chaleur générée lors du fonctionnement des composants électroniques 40 peut être dissipée par le contact avec les zones de réception des premières surfaces externes 22, 32 ainsi que par le fluide de refroidissement 60 circulé dans les parties creuses de l'unité de refroidissement 101a ou 101b.

Pour l'unité de refroidissement, la première ouverture de connexion 25 est située à une extrémité de la première portion 20 qui est distale de la zone de jonction 51. La deuxième ouverture de connexion 35 est située vers une extrémité de la deuxième portion 30. De préférence, la deuxième ouverture de connexion 35 est formée à la première surface externe 32, en se situant dans une zone différente de la zone de réception de la première surface externe 32, comme illustré en figure 1.

La première ouverture de connexion 25 de l'une des unités de refroidissement (e.g. « 101a ») est configurée pour être connectée de manière étanche, à la deuxième ouverture de connexion 35 de l'autre des unités de refroidissement (e.g. « 101b »). Un joint étanche 52 du module refroidissement 10 est ainsi formé lors de l'assemblage. De manière similaire, la deuxième ouverture de connexion 35 de l'une des unités de refroidissement (e.g. « 101a ») est configurée pour être connectée, de manière étanche, à la première ouverture de connexion 25 de l'autre des unités de refroidissement (e.g. « 101b »). Un autre joint étanche 52 est donc formé lors de l'assemblage, comme illustré en figures 1 et 2. Les joints étanches 52 du module refroidissement 10 permettent la circulation du fluide de refroidissement 60 dans le module de refroidissement composé des unités de refroidissement distinctes, sans fuite du fluide de refroidissement 60.

Il est à noter que pour faciliter les phases de test et de fabrication, les composants électroniques 40 peuvent être montés aux unités de refroidissement, préalablement à l'assemblage des unités de refroidissement. Des sous-ensembles électriques sont ainsi formés. Par exemple, l'unité de refroidissement 101a et les composants électroniques 40 y montés forment un sous-ensemble électrique, et l'unité de refroidissement 101b et les composants électroniques 40 y montés forment un autre sous-ensemble électrique.

Les sous-ensembles électriques peuvent être testés séparément, ce qui permet donc de réduire le coût des rebuts de fin de ligne. L'assemblage des sous-ensembles électriques forme donc l'ensemble électrique 1.

Après l'assemblage des unités de refroidissement (ou l'assemblage des sous-ensembles électriques), le fluide de refroidissement 60 peut donc circuler dans les parties creuses des unités de refroidissement 101a et 101b du module de refroidissement 10, depuis l'entrée de fluide (e.g. l'orifice 55 de l'unité de refroidissement 101a) vers la sortie de fluide (e.g. l'orifice 55 de l'unité de refroidissement 101b) du module de refroidissement 10, comme décrit en figures 2 et 3. Par rapport aux modules de refroidissement conventionnels, un tel module de refroidissement 10 ne présente plus de problèmes concernant l'interconnexion des composants électroniques et des unités de refroidissement.

La présente invention présente donc plusieurs avantages. Les unités de refroidissement présentent une structure simple et robuste. Elles sont faciles à fabriquer (e.g. à mouler) et à assembler pour former un circuit de refroidissement. Le module de refroidissement est composé d'unités de refroidissement de préférence identiques, ce qui permet, d'une part, de simplifier la fabrication du module de refroidissement et de l'ensemble électrique et, d'autre part, d'adapter à divers composants électroniques. Il n'est ainsi plus nécessaire de fabriquer des éléments de module de refroidissement de diverses formes et structures.

Le module de refroidissement selon l'invention ainsi que l'ensemble électrique dans lequel le module de refroidissement est intégré, sont moins volumineux et moins coûteux, plus légers et robustes que les systèmes de refroidissement et les ensembles électriques conventionnels.

L'invention n'est pas limitée aux modes de réalisation précédemment décrits mais s'étend à tout mode de réalisation conforme à son esprit.

## Revendications

1. Unité de refroidissement (101a, 101b) pour former un module de refroidissement (10) configuré pour dissiper la chaleur générée par des composants électroniques (40) d'un ensemble électrique (1), l'unité de refroidissement (101a, 101b) comprenant une première portion (20) et une deuxième portion (30), chacune étant de forme sensiblement parallélépipédique et formant une partie creuse respective, ladite unité de refroidissement étant **caractérisée en ce que** :
- les première et deuxième portions (20, 30) se rejoignent en une zone de jonction (51) de l'unité de refroidissement (101a, 101b), les première et deuxième portions (20, 30) comprenant chacune une première surface externe (22, 32) tournée vers l'autre portion (32, 22), et lesdites premières surfaces externes (22, 32) comprenant chacune une zone de réception destinée à recevoir un ou plusieurs desdits composants électroniques (40) ;
- au moins une desdites portions (20, 30) comprend une ouverture de connexion (25 ou 35) configurée pour être connectée à une autre partie dudit module de refroidissement (10) qui est distincte de ladite unité de refroidissement;
- l'unité refroidissement (101a, 101b) comprend en outre au moins un orifice (55) formé dans l'une des portions (20,30), dite portion d'entrée/sortie, l'orifice (55) débouchant dans la partie creuse de ladite portion (20,30), l'orifice (55) étant utilisé comme une entrée de fluide ou une sortie de fluide du module de refroidissement (10).

2. Unité de refroidissement (101a, 101b) selon la revendication 1, dans laquelle la première portion (20) comprend une ouverture de connexion (25) située à une extrémité de la première portion (20) qui est distale de la zone de jonction (51) de l'unité de refroidissement (101a, 101b).

3. Unité de refroidissement (101a, 101b) selon l'une quelconque des revendications précédentes, dans laquelle la deuxième portion (30) comprend une ouverture de connexion (35) formée à sa première surface externe (32), et qui se situe dans une zone différente de la zone de réception de ladite première surface externe (32) de la deuxième portion (30).

4. Unité de refroidissement (101a, 101b) selon l'une quelconque des revendications précédentes, dans laquelle les parties creuses sont configurées pour permettre la circulation d'un fluide de refroidissement (60).

5. Unité de refroidissement (101a, 101b) selon l'une quelconque des revendications précédentes, dans laquelle un angle intérieur entre les première et deuxième portions (20, 30) de l'unité de refroidissement (101a, 101b) est égal à 90 degrés.

6. Unité de refroidissement (101a, 101b) selon l'une quelconque des revendications précédentes, dans laquelle l'orifice (55) est formé sur une deuxième surface externe (23) de la portion d'entrée/sortie (20,30), ladite deuxième surface externe (23) étant opposée à ladite première surface externe (22, 32) de la portion d'entrée/sortie (20,30).

7. Module de refroidissement (10) destiné à être intégré dans un ensemble électrique (1) d'un véhicule automobile électrique ou hybride pour dissiper la chaleur générée par des composants électroniques (40) de l'ensemble électrique (1), le module de refroidissement (10) étant caractérise en ce qu'il comprend des unités de refroidissement (101a, 101b) respectivement selon l'une quelconque des revendications 1 à 6.

8. Module de refroidissement (10) selon la revendication 7, dans lequel les unités de refroidissement (101a, 101b) sont assemblées de sorte à former un circuit de refroidissement à fluide configuré pour acheminer un fluide de refroidissement (60).

9. Module de refroidissement (10) selon l'une quelconque des revendications 7 et 8, dans lequel :
- un nombre d'unités de refroidissement (101a, 101b) est égal à deux ;
- pour chacune des unités de refroidissement (101a, 101b), la première portion (20) comprend une première ouverture de connexion (25), et la deuxième portion (30) comprend une deuxième ouverture de connexion (35) ;
- les première et deuxième ouvertures de connexion (25, 35) de l'une (101a) des unités de refroidissement sont respectivement connectées, de manière étanche, à la deuxième ouverture de connexion (35) et à la première ouverture de connexion (25) de l'autre (101b) des unités de refroidissement.

10. Module de refroidissement (10) selon l'une quelconque des revendications 7 à 9, dans lequel l'orifice (55) de l'une (101a) des unités de refroidissement, et celui de l'autre (101b) des unités de refroidissement, sont respectivement utilisés comme une entrée de fluide et comme une sortie de fluide du module de refroidissement (10).

11. Module de refroidissement (10) selon l'une quelconque des revendications 7 à 10, comprenant le fluide de refroidissement (60) utilisé pour dissiper la chaleur générée par les composants électroniques (40).

12. Ensemble électrique (1) pour un véhicule automobile électrique ou hybride, comprenant des composants électroniques (40) et un module de refroidissement (10) selon l'une quelconque des revendications 7 à 11.

13. Ensemble électrique (1) selon la revendication 12, dans lequel les composants électroniques (40) comprennent un ou plusieurs composants électroniques de puissance, et/ou un ou plusieurs composants capacitifs.

14. Ensemble électrique (1) selon l'une quelconque des revendications 12 et 13, formant un onduleur ou un convertisseur de tension continu-continu.
